# EUROPEAN PATENT SPECIFICATION

(11) **EP 4 220 945 B1**
(45) Date of publication and mention of the grant of the patent: **04.11.2026**
(21) Application number: 23153108.8
(22) Date of filing: 24.01.2023
(51) Int. Cl.: H03F 1/02, H03F 3/195, H03F 3/213, H03F 3/24, H03F 3/30

(54) **VOLTAGE RIPPLE REDUCTION IN A POWER MANAGEMENT CIRCUIT**
SPANNUNGSWELLIGKEITSREDUKTION IN EINER LEISTUNGSVERWALTUNGSSCHALTUNG
RÉDUCTION D'ONDULATION DE TENSION DANS UN CIRCUIT DE GESTION D'ÉNERGIE

(30) Priority: 27.01.2022 US 202263303532 P; 27.05.2022 US 202217826311
(43) Date of publication of application: 02.08.2023
(60) Divisional application: 26208791.9
(73) Proprietor: Qorvo US, Inc., Greensboro, NC 27409 (US)
(72) Inventor: KAY, Michael R., Greensboro, 27409 (US); KHLAT, Nadim, 31770 Colomiers (FR)
(74) Representative: D Young & Co LLP

(56) References cited:
- EP-B1- 2 705 604
- US-B2- 9 112 413
- TAE-WOO KWAK ET AL: "A 2 W CMOS Hybrid Switching Amplitude Modulator for EDGE Polar Transmitters", IEEE JOURNAL OF SOLID-STATE CIRCUITS, IEEE, USA, vol. 42, no. 12, 1 December 2007 (2007-12-01), pages 2666 - 2676, XP011197154, ISSN: 0018-9200, DOI: 10.1109/JSSC.2007.908769
- PAEK JI-SEON ET AL: "A - 137 dBm/Hz Noise, 82% Efficiency AC-Coupled Hybrid Supply Modulator With Integrated Buck-Boost Converter", IEEE JOURNAL OF SOLID-STATE CIRCUITS, IEEE, USA, vol. 51, no. 11, 1 November 2016 (2016-11-01), pages 2757 - 2768, XP011626629, ISSN: 0018-9200, [retrieved on 20161024], DOI: 10.1109/JSSC.2016.2604296

## Description

### Related Applications

This application claims the benefit of U.S. provisional patent application serial number 63/303,532, filed on January 27, 2022.

### Field of the Disclosure

The technology of the disclosure relates generally to reducing voltage ripple in a modulated voltage in a power management circuit.

### Background

Fifth generation (5G) new radio (NR) (5G-NR) has been widely regarded as the next generation of wireless communication technology beyond the current third generation (3G) and fourth generation (4G) technologies. In this regard, a wireless communication device capable of supporting the 5G-NR wireless communication technology is expected to achieve higher data rates, improved coverage range, enhanced signaling efficiency, and reduced latency.

Downlink and uplink transmissions in a 5G-NR system are widely based on orthogonal frequency division multiplexing (OFDM) technology. In an OFDM based system, physical radio resources are divided into a number of subcarriers in a frequency domain and a number of OFDM symbols in a time domain. The subcarriers are orthogonally separated from each other by a subcarrier spacing (SCS). The OFDM symbols are separated from each other by a cyclic prefix (CP), which acts as a guard band to help overcome inter-symbol interference (ISI) between the OFDM symbols.

A radio frequency (RF) signal communicated in the OFDM based system is often modulated into multiple subcarriers in the frequency domain and multiple OFDM symbols in the time domain. The multiple subcarriers occupied by the RF signal collectively define a modulation bandwidth of the RF signal. The multiple OFDM symbols, on the other hand, define multiple time intervals during which the RF signal is communicated. In the 5G-NR system, the RF signal is typically modulated with a high modulation bandwidth in excess of 200 MHz (e.g., 1 GHz).

The duration of an OFDM symbol depends on the SCS and the modulation bandwidth. The table below (Table 1) provides some OFDM symbol durations, as defined by 3G partnership project (3GPP) standards for various SCSs and modulation bandwidths. Notably, the higher the modulation bandwidth is, the shorter the OFDM symbol duration will be. For example, when the SCS is 120 KHz and the modulation bandwidth is 400 MHz, the OFDM symbol duration is 8.93 µs.

**Table 1**

| SCS (KHz) | CP (µs) | OFDM Symbol Duration (µs) | Modulation Bandwidth (MHz) |
|---|---|---|---|
| 15 | 4.69 | 71.43 | 50 |
| 30 | 2.34 | 35.71 | 100 |
| 60 | 1.17 | 17.86 | 200 |
| 120 | 0.59 | 8.93 | 400 |

Notably, the wireless communication device relies on a battery cell (e.g., Li-lon battery) to power its operations and services. Despite recent advancement in battery technologies, the wireless communication device can run into a low battery situation from time to time. In this regard, it is desirable to prolong battery life concurrent to enabling fast voltage changes between the OFDM symbols.
TAE-WOO KWAK ET AL: "A 2 W CMOS Hybrid Switching Amplitude Modulator for EDGE Polar Transmitters", IEEE JOURNAL OF SOLID-STATE CIRCUITS, IEEE, USA, vol. 42, no. 12, 1 December 2007 (2007-12-01), pages 2666-2676, discusses a hybrid switching amplitude modulator for class-E2 EDGE polar transmitters which consists of a wideband buffered linear amplifier as a voltage source and a PWM switching amplifier with a 2 MHz switching frequency as a dependent current source.
US 9 112 413 B2 discusses a switched mode assisted linear regulator with AC coupling with capacitive charge control.
EP 2 705 604 B1 discusses a power management system for pseudo-envelope and average power tracking.
PAEK JI-SEON ET AL: "A -137 dBm/Hz Noise, 82% Efficiency AC-Coupled Hybrid Supply Modulator With Integrated Buck-Boost Converter", IEEE JOURNAL OF SOLID-STATE CIRCUITS, IEEE, USA, vol. 51, no.11, 1 November2016 (2016-11-01), pages2757-2768, discusses a hybrid supply modulator (SM) with a comprehensive analysis of receiver (RX) band noise in an envelope tracking power amplifier (ET-PA).

### Summary

Particular embodiments are set out in the independent claims. Various optional examples are set out in the dependent claims. Embodiments of the disclosure relate to voltage ripple reduction in a power management circuit. The power management circuit includes a power amplifier circuit configured to amplify a radio frequency (RF) signal based on a modulated voltage and an envelope tracking integrated circuit (ETIC) configured to provide the modulated voltage to the power amplifier circuit via a conductive path. Notably, an output impedance (e.g., an inductive impedance associated with the ETIC and the conductive path) presenting at an input of the power amplifier circuit interacts with a modulated load current in the power amplifier circuit to create a voltage ripple in the modulated voltage to potentially cause an undesirable error in the RF signal. In embodiments disclosed herein, the ETIC is configured to modify the modulated voltage based on feedback that indicates the voltage ripple in the modulated voltage as received at the power amplifier input. By modifying the modulated voltage based on knowledge of the voltage ripple, it is possible to reduce the output impedance at the input of the power amplifier circuit to thereby reduce the voltage ripple in the modulated voltage.

In one aspect, a power management circuit is provided. The power management circuit includes a power amplifier circuit. The power amplifier circuit is configured to amplify an RF signal based on a modulated voltage received at a power amplifier input. The modulated voltage received at the power amplifier input comprises a voltage ripple caused by an output impedance presenting at the power amplifier input. The power management circuit also includes an ETIC. The ETIC includes a voltage output coupled to the power amplifier input via a conductive path. The ETIC also includes a voltage modulation circuit. The voltage modulation circuit is configured to generate the modulated voltage at the voltage output based on a modulated target voltage. The voltage modulation circuit is also configured to receive power amplifier voltage feedback indicating the voltage ripple in the modulated voltage received at the power amplifier input. The voltage modulation circuit is also configured to modify the modulated voltage based on the power amplifier voltage feedback to cause a reduction in the output impedance to thereby reduce the voltage ripple in the modulated voltage received at the power amplifier input.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1A is a schematic diagram of an example existing transmission circuit wherein a power management circuit is configured to reduce a voltage ripple in a modulated voltage based on a conventional approach;
Figure 1B is a schematic diagram of an example electrical model of the power management circuit in Figure 1A;
Figure 1C is a graphic diagram providing an example illustration of magnitude impedance as a function of modulation frequency;
Figure 2 is a schematic diagram of an example power management circuit configured according to an embodiment of the present disclosure to reduce a voltage ripple in a modulated voltage by reducing an output impedance presenting at a power amplifier input of a power amplifier circuit; and
Figure 3 is a schematic diagram providing an example illustration of an inner structure of a voltage amplifier in the power management circuit of Figure 2.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments of the disclosure relate to voltage ripple reduction in a power management circuit. The power management circuit includes a power amplifier circuit configured to amplify a radio frequency (RF) signal based on a modulated voltage and an envelope tracking integrated circuit (ETIC) configured to provide the modulated voltage to the power amplifier circuit via a conductive path. Notably, an output impedance (e.g., an inductive impedance associated with the ETIC and the conductive path) presenting at an input of the power amplifier circuit can interact with a modulated load current in the power amplifier circuit to create a voltage ripple in the modulated voltage to potentially cause an undesirable error in the RF signal. In embodiments disclosed herein, the ETIC is configured to modify the modulated voltage based on feedback that indicates the voltage ripple in the modulated voltage as received at the power amplifier input. By modifying the modulated voltage based on knowledge of the voltage ripple, it is possible to reduce the output impedance at the input of the power amplifier circuit to thereby reduce the voltage ripple in the modulated voltage.

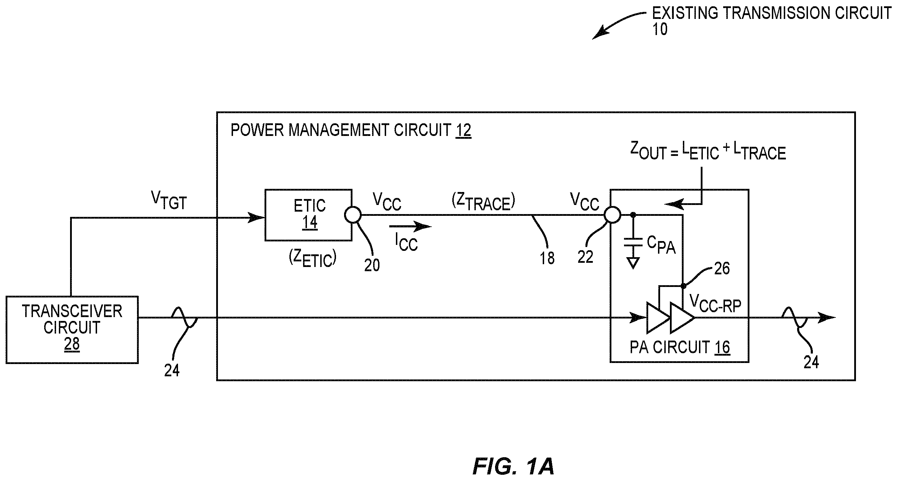

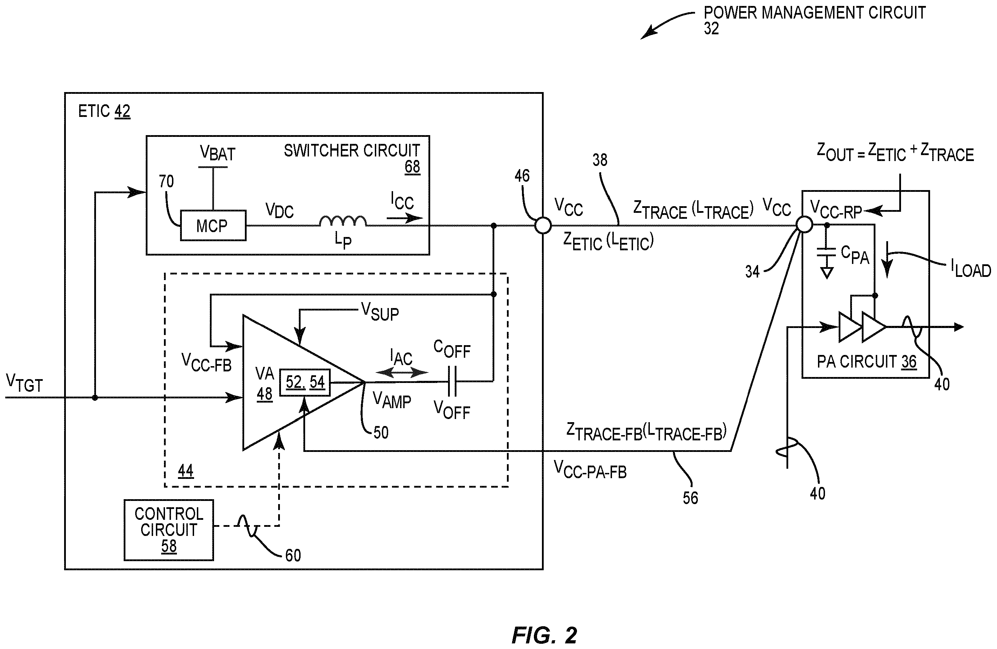

Before discussing the specific voltage ripple reduction embodiment of the present disclosure, starting at Figure 2, a brief overview of an existing transmission circuit is first discussed with reference to Figures 1A-1C to help understand some issues related to reducing voltage ripple based conventional approaches.

Figure 1A is a schematic diagram of an example existing transmission circuit 10 wherein a power management circuit 12 is configured to reduce a voltage ripple V_{CC-RP} in a modulated voltage V_{CC} based on a conventional approach. The power management circuit 12 includes an ETIC 14 and a power amplifier circuit 16. The ETIC 14 is configured to generate the modulated voltage V_{CC} based on a modulated target voltage V_{TGT} and provide the modulated voltage V_{CC} to the power amplifier circuit 16 via a conductive path 18 (e.g., a conductive trace), which is coupled between a voltage output 20 of the ETIC 14 and a power amplifier input 22 of the power amplifier circuit 16. The power amplifier circuit 16 is configured to amplify an RF signal 24 based on the modulated voltage V_{CC}.

Notably, there may be an internal routing distance from the power amplifier input 22 to an actual voltage input 26 (e.g., a collector node) of the power amplifier circuit. Given that the internal routing distance is far shorter than the conductive path 18, the internal routing distance is thus neglected hereinafter. Accordingly, the power amplifier input 22 as illustrated herein can be equated with the actual voltage input 26 of the power amplifier circuit 16.

The power management circuit 12 may be coupled to a transceiver circuit 28. Herein, the transceiver circuit 28 is configured to generate the RF signal 24 and the modulated target voltage V_{TGT}.

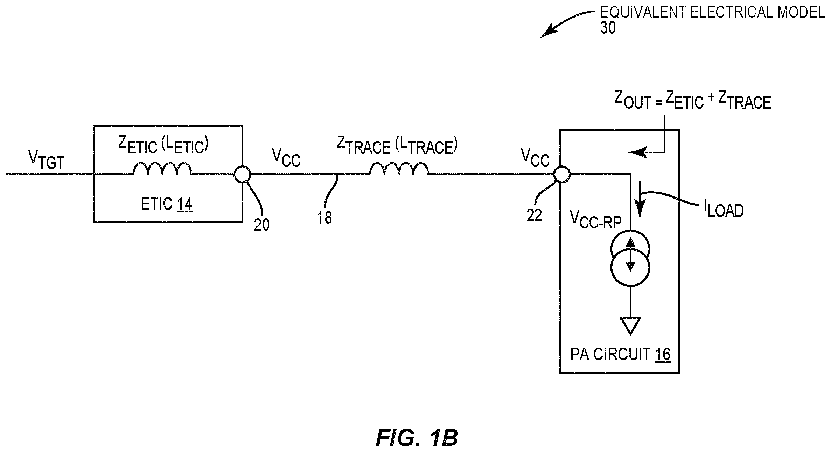

The voltage ripple V_{CC-RP} can be quantitively analyzed based on an equivalent electrical model of the power management circuit 12. In this regard, Figure 1B is a schematic diagram of an example equivalent electrical model 30 of the power management circuit 12 in Figure 1A. Common elements between Figures 1A and 1B are shown therein with common element numbers and will not be re-described herein.

The ETIC 14 inherently has an inductive impedance Z_{ETIC} that can be modeled by an ETIC inductance L_{ETIC}. The conductive path 18 can also be associated with an inductive trace impedance Z_{TRACE} that can be modeled by a trace inductance L_{TRACE}. As a result, looking from the power amplifier input 22 toward the ETIC 14, the power amplifier circuit 16 will see an output impedance Z_{OUT} that includes both the inductive impedance Z_{ETIC} and the inductive trace impedance Z_{TRACE}.

The power amplifier circuit 16 can be modeled as a current source. In this regard, the power amplifier circuit 16 will modulate a load current I_{LOAD} based on the modulated voltage V_{CC}. The load current I_{LOAD} can interact with the output impedance Z_{OUT} to create the voltage ripple V_{CC-RP} in the modulated voltage V_{CC} received at the power amplifier input 22. In this regard, the voltage ripple V_{CC-RP} is a function of the modulated load current I_{LOAD} and the output impedance Z_{OUT}, as expressed in equation (Eq. 1) below. ${V}_{CC - RP} = {I}_{LOAD} * {Z}_{OUT}$ (Eq. 1)

Notably from the equation (Eq. 1), it may be possible to reduce the voltage ripple V_{CC-RP} by lowering the output impedance Z_{OUT} seen at the power amplifier input 22. In this regard, the conventional approach for reducing the voltage ripple V_{CC-RP} in the power management circuit 12 of Figure 1A is to add a decoupling capacitor C_{PA} inside the power amplifier circuit 16 and be as close to the power amplifier input 22 as possible. By adding the decoupling capacitor C_{PA}, the output impedance Z_{OUT} can be simply expressed as in equation (Eq. 2). ${Z}_{OUT} = {Z}_{CPA} \left‖\left({Z}_{ETIC}+{Z}_{TRACE}\right)\right.$ (Eq. 2)

In the equation (Eq. 2), Z_{CPA} represents a capacitive impedance of the decoupling capacitor C_{PA}. The capacitive impedance Z_{CPA} and the inductive impedance Z_{ETIC} and Z_{TRACE} can each be determined according to equations (Eq. 3.1-3.3) below. $\left|{Z}_{CPA}\right| = 1 / 2 πf * {C}_{PA}$ (Eq. 3.1) $\left|{Z}_{ETIC}\right| = 2 πf * {L}_{ETIC}$ (Eq. 3.2) $\left|{Z}_{TRACE}\right| = 2 πf * {L}_{TRACE}$ (Eq. 3.3)

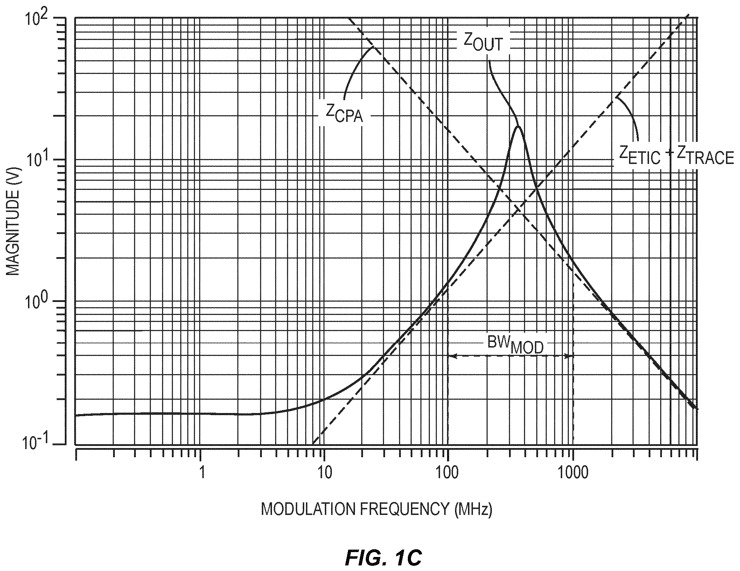

In the equations (Eq. 3.1-3.3), f represents the modulation frequency of the load current I_{LOAD}. In this regard, the capacitive impedance Z_{CPA}, the inductive impedance Z_{ETIC}, and the inductive trace impedance Z_{TRACE} are each a function of the modulation frequency f. Figure 1C is a graphic diagram providing an example illustration of magnitude impedance vs. the modulation frequency f.

When the modulation frequency *f* is lower than 10 MHz, the output impedance Z_{OUT} is dominated by a real part of the inductive impedance Z_{ETIC} and a real part of the inductive trace impedance Z_{TRACE}. Between 10 MHz and 100 MHz, the output impedance Z_{OUT} is dominated by the inductive impedance Z_{ETIC} and the inductive trace impedance Z_{TRACE}. Above 1000 MHz, the output impedance Z_{OUT} will be dominated by the capacitive impedance Z_{CPA}.

Herein, a modulation bandwidth BW_{MOD} of the RF signal 24 may fall between 100 MHz and 1000 MHz (e.g., 100-500 MHz). In this frequency range, the output impedance Z_{OUT} will be determined by the output impedance Z_{OUT} as expressed in equation (Eq. 2).

Notably from equations (Eq. 2 and 3.1), the capacitive impedance Z_{CPA}, and therefore the output impedance Z_{OUT}, will decrease as the capacitance C_{PA} increases. In this regard, the conventional approach for reducing the ripple voltage V_{CC-RP} relies largely on adding the decoupling capacitor C_{PA} with a larger capacitance (e.g., 1 to 2 *µ*F). However, doing so can cause some obvious issues.

Understandably, a rate of change of the modulated voltage V_{CC} (ΔV_{CC} or dV/dt) can be inversely affected by the capacitance of the decoupling capacitor C_{PA}, as shown in equation (Eq. 4) below. ${ΔV}_{CC} = {I}_{CC} / {C}_{PA}$ (Eq. 4)

In the equation (Eq. 4), I_{CC} represents a low-frequency current (a.k.a. in-rush current) provided by the ETIC 14 when the decoupling capacitor C_{PA} is charged or discharged. In this regard, the larger capacitance the decoupling capacitor C_{PA} has, the larger amount of the low-frequency current I_{CC} would be needed to change the modulated voltage V_{CC} at a required rate of change (ΔV_{CC}). As a result, the existing transmission circuit 10 may cause a negative impact on battery life.

If the low-frequency current I_{CC} is kept at a low level to prolong battery life, the existing transmission circuit 10 may have difficulty meeting the required rate of change (ΔV_{CC}), particularly when the RF signal 24 is modulated based on orthogonal frequency division multiplexing (OFDM) for transmission in a millimeter wave (mmWave) spectrum. Consequently, the existing transmission circuit 10 may not be able to change the modulated voltage V_{CC} in between OFDM symbols.

On the other hand, if the capacitance of the decoupling capacitor C_{PA} is reduced to help improve the rate of change (ΔV_{CC}) of the modulated voltage V_{CC} and reduce the in-rush current I_{CC}, doing so may lead to insufficient reduction of the output impedance Z_{OUT} and, thus, the voltage ripple V_{CC-RP}. Hence, it is desirable to sufficiently reduce the ripple voltage V_{CC-RP} within the modulation bandwidth BW_{MOD} concurrent to improving the rate of change (ΔV_{CC}) of the modulated voltage V_{CC} and reducing the in-rush current I_{CC}.

Figure 2 is a schematic diagram of an example power management circuit 32 configured according to an embodiment of the present disclosure to reduce a voltage ripple V_{CC}. _{RP} in a modulated voltage V_{CC} by reducing an output impedance Z_{OUT} presenting at a power amplifier input 34 of a power amplifier circuit 36. Herein, the power amplifier circuit 36 is configured to receive the modulated voltage V_{CC} via a conductive path 38 (e.g., a conductive trace) and amplify an RF signal 40 based on the modulated voltage V_{CC}. The power amplifier circuit 36 includes a decoupling capacitor C_{PA}. Similar to the decoupling capacitor C_{PA} in the power amplifier circuit 16 in Figure 1A, the decoupling capacitor C_{PA} is also provided as close to the power amplifier input 34 as possible.

The power management circuit 32 includes an ETIC 42. The ETIC 42 includes a voltage modulation circuit 44. The voltage modulation circuit 44 is configured to generate the modulated voltage V_{CC} at a voltage output 46 based on a modulated target voltage V_{TGT}. Herein, the voltage output 46 is coupled to the power amplifier input 34 via the conductive path 38.

Like the power management circuit 12 in Figure 1A, the decoupling capacitor C_{PA} has a capacitive impedance Z_{CPA}, the ETIC 42 inherently has an inductive impedance Z_{ETIC}, and the conductive path 38 is inherently associated with an inductive trace impedance Z_{TRACE}, which can be expressed as in the equations (Eq. 3.1-3.3). Accordingly, the power amplifier circuit 36 will see an output impedance Z_{OUT}, as determined in the equation (Eq. 2), within a modulation bandwidth (e.g., 100-500 MHz) of the RF signal 40. Herein, the power amplifier circuit 36 also operates as a current source, which can induce a modulated load current I_{LOAD} based on the modulated voltage V_{CC}. Similar to the power management circuit 12 in Figure 1A, the modulated load current I_{LOAD} can interact with the output impedance Z_{OUT} to create a voltage ripple V_{CC-RP} in the modulated voltage V_{CC} received at the power amplifier input 34.

In embodiments disclosed herein, the decoupling capacitor C_{PA} has a smaller capacitance (e.g., 100 pF) compared to the decoupling capacitor C_{PA} in the power amplifier circuit 16 in Figure 1A. By employing the smaller decoupling capacitor C_{PA}, it is possible to improve the rate of change (ΔV_{CC}) of the modulated voltage V_{CC} to satisfy the stringing voltage switching time requirement (e.g., per OFDM symbol or sub-symbol) in such advanced wireless systems as fifth generation (5G) and 5G new-radio (5G-NR), while concurrently reducing the in-rush current I_{CC} to prolong battery life.

Further, the power management circuit 32 is configured to reduce the voltage ripple V_{CC-RP} in the modulated voltage V_{CC} by reducing the output impedance P_{OUT} presenting at the power amplifier input 34 and/or creating a notch filter at the power amplifier input 34. As a result, the power management circuit 32 can achieve a defined performance threshold, such as RMS EVM and/or peak EVM within the modulation bandwidth of the RF signal 40.

In an embodiment, the voltage modulation circuit 44 includes a voltage amplifier 48 (denoted as "VA"), which can be an operational amplifier (OpAmp), as an example. The voltage amplifier 48 is configured to generate an initial modulated voltage V_{AMP} at a voltage amplifier output 50 based on the modulated target voltage V_{TGT} and a supply voltage V_{SUP}. The voltage modulation circuit 44 also includes an offset capacitor C_{OFF} that is coupled in between the voltage amplifier output 50 and the voltage output 46. The offset capacitor C_{OFF} is configured to raise the initial modulated voltage V_{AMP} by an offset voltage V_{OFF} to thereby generate the modulated voltage V_{CC} at the voltage output 46 (V_{CC} = V_{AMP} + V_{OFF}).

The voltage amplifier 48 is also configured to receive a modulated voltage feedback V_{CC-FB} that indicates the modulated voltage V_{CC} at the voltage output 46, thus making the voltage modulation circuit 44 a closed-loop circuit. Accordingly, the voltage amplifier 48 can adjust the initial modulated voltage V_{AMP} and, thus the modulated voltage V_{CC}, based on the modulated feedback V_{CC-FB} to better track the modulated target voltage V_{TGT}.

The voltage amplifier 48 includes an input/bias stage 52 and an output stage 54. The output stage 54 is coupled in series to the voltage amplifier output 50. According to an embodiment of the present disclosure, the output stage 54 is configured to receive a power amplifier voltage feedback V_{CC-PA-FB} that indicates the modulated voltage V_{CC} as received at the power amplifier input 34. The output stage 54 may receive the power amplifier voltage feedback V_{CC-PA-FB} via a feedback path 56. Like the conductive path 38, the feedback path 56 is associated with an inductive feedback trace impedance Z_{TRACE-FB} that can be modeled by a feedback inductance L_{TRACE-FB}.

Understandably, since the power amplifier voltage feedback V_{CC-PA-FB} is provided from the power amplifier input 34, the power amplifier voltage feedback V_{CC-PA-FB} will include the voltage ripple V_{CC-RP} in the modulated voltage V_{CC} as received at the power amplifier input 34. Accordingly, the voltage amplifier 48 may modify the initial modulated voltage V_{AMP} based on the power amplifier voltage feedback V_{CC-PA-FB} to cause the output impedance Z_{OUT} to be reduced at the power amplifier input 34, thus helping to reduce the voltage ripple V_{CC-RP} in the modulated voltage V_{CC} that is received at the power amplifier input 34.

The ETIC 42 may include a control circuit 58, which can be a field-programmable gate array (FPGA) or an application-specific integrated circuit (ASIC), as an example. In an embodiment, the control circuit 58 may control the voltage amplifier 48, for example, via a control signal 60, to modify the initial modulated voltage V_{AMP} based on the power amplifier voltage feedback V_{CC-PA-FB} to thereby reduce the output impedance Z_{OUT} at the power amplifier input 34.

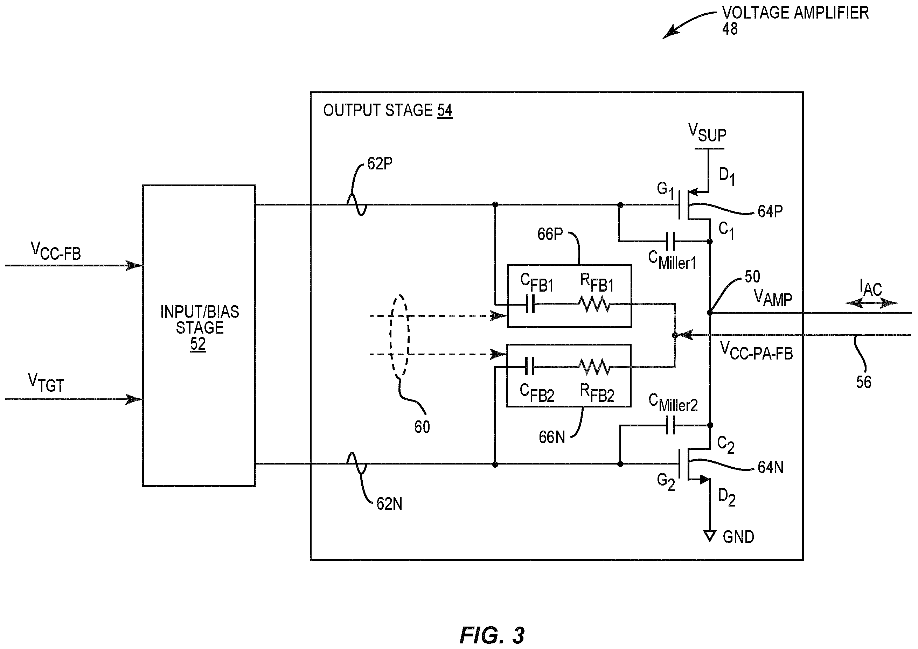

Figure 3 is a schematic diagram providing an example illustration of an inner structure of the voltage amplifier 48 in Figure 2. Common elements between Figures 2 and 3 are shown therein with common element numbers and will not be re-described herein.

In an embodiment, the input/bias stage 52 is configured to receive the modulated voltage V_{TGT} and the modulated voltage feedback V_{CC-FB}. Accordingly, the input/bias stage 52 generates a pair of bias signals 62P (a.k.a. first bias signal), 62N (a.k.a. second bias signal) to control the output stage 54.

In an embodiment, the output stage 54 is configured to generate the initial modulated voltage V_{AMP} at the voltage amplifier output 50 based on a selected one of the bias signals 62P, 62N. The output stage 54 is also configured to receive the power amplifier voltage feedback V_{CC-FB}. Accordingly, the output stage 54 modifies the initial modulated voltage V_{AMP} based on the power amplifier voltage feedback V_{CC-FB} to reduce the output impedance Z_{OUT} and thereby the voltage ripple V_{CC-RP} at the power amplifier input 34.

In an embodiment, the output stage 54 includes a first transistor 64P and a second transistor 64N. In a non-limiting example, the first transistor 64P is a p-type field-effect transistor (pFET) and the second transistor 64N is an n-type FET (nFET). In this example, the first transistor 64P includes a first source electrode C₁, a first drain electrode D₁, and a first gate electrode G₁, and the second transistor 64N includes a second source electrode C₂, a second drain electrode D₂, and a second gate electrode G₂. Specifically, the first drain electrode D₁ is configured to receive the supply voltage V_{SUP}, the second drain electrode D2 is coupled to a ground (GND), and the first source electrode C₁ and the second source electrode C₂ are both coupled to the voltage amplifier output 50.

The first gate electrode G₁ is coupled to the input/bias stage 52 to receive the bias signal 62P and the second gate electrode G₂ is coupled to the input/bias stage 52 to receive the bias signal 62N. Herein, the input/bias stage 52 is configured to generate the bias signal 62P in response to an increase of the modulated voltage V_{CC} or generate the bias signal 62N in response to a decrease of the modulated voltage V_{CC}. Specifically, the first transistor 64P will be turned on to output the initial modulated voltage V_{AMP} and source a high-frequency current I_{AC} (e.g., an alternating current) from the supply voltage V_{SUP} in response to receiving the bias signal 62P, and the second transistor 64N will be turned on to output the initial modulated voltage V_{AMP} from the supply voltage V_{SUP} and sink the high-frequency current I_{AC} to the GND in response to receiving the bias signal 62N.

In this embodiment, the output stage 54 also includes a first Miller capacitor C_{Miller1} and a second Miller capacitor C_{Miller2}. Specifically, the first Miller capacitor C_{Miller1} is coupled between the voltage amplifier output 50 and the first gate electrode G₁, and the second Miller capacitor C_{Miller2} is coupled between the voltage amplifier output 50 and the second gate electrode G₂. In this regard, the output stage 54 can be regarded as a typical class AB rail-rail OpAmp output stage. The first Miller capacitor C_{Miller1} and the second Miller capacitor C_{Miller2} not only can stabilize controls of the first transistor 64P and the second transistor 64N (e.g., mitigating so-called Miller effect), but may also reduce the closed-loop output impedance of the voltage amplifier 48.

Notably, since the first Miller capacitor C_{Miller1} and the second Miller capacitor C_{Miller2} are each coupled to the voltage amplifier output 50, the first Miller capacitor C_{Miller1} and the second Miller capacitor C_{Miller2} can only reduce the inductive impedance Z_{ETIC}, which is part of the output impedance Z_{OUT} seen at the power amplifier input 34. As such, to further reduce the output impedance Z_{OUT}, it is also necessary to reduce the inductive trace impedance Z_{TRACE}.

In this regard, the output stage 54 further includes a first resistor-capacitor (RC) circuit 66P and a second RC circuit 66N. The first RC circuit 66P and the second RC circuit 66N are both coupled to the power amplifier input 34 via the feedback path 56 to thereby receive the power amplifier voltage feedback V_{CC-FB}. Specifically, the first RC circuit 66P is coupled between the power amplifier input 34 and the first gate electrode G₁, and the second RC circuit 66N is coupled between the power amplifier input 34 and the second gate electrode G₂. As such, the first RC circuit 66P can cause the power amplifier voltage feedback V_{CC-FB} to be combined with the bias signal 62P to thereby modify the bias signal 62P. Similarly, the second RC circuit 66N can cause the power amplifier voltage feedback V_{CC-FB} to be combined with the bias signal 62N to thereby modify the bias signal 62N.

In an embodiment, the first RC circuit 66P includes a first adjustable resistor R_{FB1} and a first adjustable capacitor C_{FB1}, and the second RC circuit 66N includes a second adjustable resistor R_{FB2} and a second adjustable capacitor C_{FB2}. Recall that the feedback path 56 is associated with the inductive feedback trace impedance Z_{TRACE-FB} that can be modeled by the feedback inductance L_{TRACE-FB}. As such, the first adjustable resistor R_{FB1}, the first adjustable capacitor C_{FB1}, and the feedback inductance L_{TRACE-FB} can be equated with a first resistor-inductor-capacitor (RLC) circuit, which has a first resonance frequency *f*₁ as expressed in equation (Eq. 5) below. ${f}_{1} = 1 / 2 π \sqrt{{L}_{TRACE - FB} * {C}_{FB 1}}$ (Eq. 5)

Likewise, the second adjustable resistor R_{FB2}, the second adjustable capacitor C_{FB2}, and the feedback inductance L_{TRACE-FB} can be equated with a second RLC circuit, which has a second resonance frequency *f*₂ as expressed in equation (Eq. 6) below. ${f}_{2} = 1 / 2 π \sqrt{{L}_{TRACE - FB} * {C}_{FB 2}}$ (Eq. 6)

From equations (Eq. 5 and 6), the first adjustable capacitor C_{FB1} and the second adjustable capacitor C_{FB2} can each be adjusted to resonate with the feedback inductance L_{TRACE-FB} to create a low-impedance feedback path at a respective one of the first resonance frequency *f*₁ and the second resonance frequency *f*₂. The first adjustable resistor R_{FB1} will de-Q the first resonance frequency *f*₁ across the modulation bandwidth BW_{MOD} to prevent the first adjustable capacitor C_{FB1} and the feedback inductance L_{TRACE-FB} from entering oscillation at the first resonance frequency *f*₁. Likewise, the second adjustable resistor R_{FB2} will de-Q the second resonance frequency *f*₂ across the modulation bandwidth BW_{MOD} to prevent the second adjustable capacitor C_{FB2} and the feedback inductance L_{TRACE-FB} from entering oscillation at the second resonance frequency *f*₂.

When the voltage ripple V_{CC-RP} seen at the power amplifier input 34 is fed back to the first gate electrode G₁ or the second gate electrode G₂, the first transistor 64P and the second transistor 64N may act like a common source amplifier, which amplifies and inverts the initial modulated voltage V_{AMP} at the voltage amplifier output 50 and, therefore, the voltage output 46 of the ETIC 42. The inverted initial modulated voltage V_{AMP} will cause more of the load current I_{LOAD} to flow to the GND through the conductive path 38 (a.k.a. the trace inductor L_{TRACE}) than flowing through the power amplifier circuit 36, thus lowering the inductive trace impedance Z_{TRACE} and, accordingly the output impedance Z_{OUT} at the power amplifier input 34.

Thus, by adjusting the first adjustable capacitor C_{FB1}, the first adjustable resistor R_{FB1}, the second adjustable capacitor C_{FB2}, and/or the second adjustable resistor R_{FB2}, it is possible to reduce the output impedance Z_{OUT} to across the modulation bandwidth BW_{MOD}. In an embodiment, the first adjustable capacitor C_{FB1}, the first adjustable resistor R_{FB1}, the second adjustable capacitor C_{FB2}, and/or the second adjustable resistor R_{FB2} may be adjusted by the control circuit 58 via the control signal 60.

By employing the first Miller capacitor C_{Miller1} and the second Miller capacitor C_{Miller2} to help reduce the inductive impedance Z_{ETIC}, and further employing the first RC circuit 66P and the second RC circuit 66N to help reduce the inductive trace impedance Z_{TRACE}, it is possible to reduce the output impedance Z_{OUT} to thereby reduce the voltage ripple V_{CC-RP} in the modulated voltage V_{CC}. A simulation shows that, at 200 MHz load current modulation frequency, the power management circuit 32 can reduce an RMS value of the voltage ripple V_{CC-RP} from 231 mV, as in the power management circuit 12 in Figure 1A, to 134 mV, which amounts to a 42% improvement.

With reference to Figure 2, the ETIC 42 further includes a switcher circuit 68. In an embodiment, the switcher circuit 68 includes a multi-level charge pump (MCP) 70 that is coupled to the voltage output 46 via a power inductor L_{P}. The MCP 70, which can be a buck-boost voltage converter, as an example, is configured to generate a low-frequency voltage V_{DC} based on a battery voltage V_{BAT}. Specifically, the MCP 70 may operate in a buck mode to generate the low-frequency voltage V_{DC} at 0×V_{BAT} or 1 ×V_{BAT}, or in a boost mode to generate the low-frequency voltage V_{DC} at 2×V_{BAT}. Thus, by configuring the MCP 70 to toggle between 0×V_{BAT}, 1 ×V_{BAT}, and/or 2×V_{BAT} based on an appropriate duty cycle, the MCP 70 can generate the low-frequency voltage V_{DC} at multiple voltage levels.

The power inductor L_{P} is configured to induce a low-frequency current I_{CC} (a.k.a. in-rush current) based on the low-frequency voltage V_{DC}. As previously described in Figure 1A, the low-frequency current I_{CC} is provided to the power amplifier input 34 to charge the decoupling capacitor C_{PA}.

Thus, from one perspective, there has now been described voltage ripple reduction in a power management circuit. The power management circuit includes a power amplifier circuit configured to amplify a radio frequency (RF) signal based on a modulated voltage and an envelope tracking integrated circuit (ETIC) configured to provide the modulated voltage to the power amplifier circuit via a conductive path. Notably, an output impedance presenting at an input of the power amplifier circuit can interact with a modulated load current in the power amplifier circuit to create a voltage ripple in the modulated voltage to potentially cause an undesirable error in the RF signal. Herein, the ETIC is configured to modify the modulated voltage based on feedback of the voltage ripple in the modulated voltage. As such, it is possible to reduce the output impedance at the input of the power amplifier circuit to thereby reduce the voltage ripple in the modulated voltage.

Those skilled in the art will recognize improvements and modifications to the preferred embodiments of the present disclosure. All such improvements and modifications are considered within the scope of the concepts disclosed herein and the claims that follow.

## Claims

1. An envelope tracking integrated circuit, ETIC, comprising:
a voltage output coupled to a power amplifier circuit via a conductive path inherently associated with an inductive trace impedance, the power amplifier circuit is configured to amplify a radio frequency, RF, signal based on a modulated voltage received at a power amplifier input, wherein the modulated voltage received at the power amplifier input comprises a voltage ripple created by an interaction of an output impedance presenting at the power amplifier input and a load current in the power amplifier circuit; and
a voltage modulation circuit comprising a voltage amplifier having an output stage coupled to the power amplifier input via a feedback path different from the conductive path, the voltage modulation circuit being configured to:
generate the modulated voltage at the voltage output based on a modulated target voltage;
receive a modulated voltage feedback indicating the modulated voltage at the voltage output;
receive a power amplifier voltage feedback indicating the voltage ripple in the modulated voltage received at the power amplifier input via the feedback path; and
modify the modulated voltage based on the modulated voltage feedback and the power amplifier voltage feedback to cause a reduction in the output impedance to thereby reduce the voltage ripple in the modulated voltage received at the power amplifier input.

2. The ETIC of claim 1, wherein the output impedance presenting at the power amplifier input comprises an inductive impedance of the ETIC and the inductive trace impedance associated with the conductive path.

3. The ETIC of claim 2, wherein the voltage modulation circuit comprises:
the voltage amplifier configured to generate an initial modulated voltage at a voltage amplifier output based on the modulated target voltage; and
an offset capacitor configured to raise the initial modulated voltage by an offset voltage to generate the modulated voltage at the voltage output.

4. The ETIC of claim 3, wherein the voltage amplifier comprises the output stage configured to:
generate the initial modulated voltage at the voltage amplifier output;
receive the power amplifier voltage feedback indicating the voltage ripple in the modulated voltage received at the power amplifier input; and
modify the initial modulated voltage based on the power amplifier voltage feedback to cause the reduction in the output impedance to thereby reduce the voltage ripple in the modulated voltage received at the power amplifier input.

5. The ETIC of claim 4, wherein the voltage amplifier further comprises an input/bias stage configured to:
receive the modulated target voltage and the modulated voltage feedback indicating the modulated voltage at the voltage output; and
generate a pair of bias signals based on the modulated target voltage and the modulated voltage feedback to thereby cause the output stage to generate the initial modulated voltage.

6. The ETIC of claim 5, wherein the output stage comprises:
a first transistor comprising:
a first drain electrode configured to receive a supply voltage;
a first gate electrode configured to receive a first bias signal among the pair of bias signals; and
a first source electrode coupled to the voltage amplifier output; and
a second transistor comprising:
a second source electrode coupled to the voltage amplifier output;
a second gate electrode configured to receive a second bias signal among the pair of bias signals; and
a second drain electrode coupled to a ground;
wherein a selected one of the first transistor and the second transistor is biased by a selected one of the first bias signal and the second bias signal to output the initial modulated voltage at the voltage amplifier output.

7. The ETIC of claim 6, wherein the output stage further comprises:
a first Miller capacitor coupled between the first gate electrode and the first source electrode and configured to reduce an impedance at the voltage output to thereby reduce the inductive impedance of the ETIC when the first transistor is biased by the first bias signal; and
a second Miller capacitor coupled between the second gate electrode and the second source electrode and configured to reduce the impedance at the voltage output to thereby reduce the inductive impedance of the ETIC when the second transistor is biased by the second bias signal.

8. The ETIC of claim 6, wherein the output stage further comprises:
a first series resistor-capacitor, RC, circuit coupled between the power amplifier input and the first gate electrode and configured to combine the power amplifier voltage feedback with the first bias signal to thereby reduce the inductive trace impedance at the power amplifier input; and
a second series RC circuit coupled between the power amplifier input and the second gate electrode and configured to combine the power amplifier voltage feedback with the second bias signal to thereby reduce the inductive trace impedance at the power amplifier input.

9. The ETIC of claim 8, wherein the first RC circuit and the second RC circuit each comprises a respective adjustable resistor and a respective adjustable capacitor coupled in series between the power amplifier input and a respective one of the first gate electrode and the second gate electrode.

10. The ETIC of claim 9, wherein the ETIC further comprises a control circuit configured to adjust at least one of the respective adjustable resistor and the respective capacitor in a respective one of the first series RC circuit and the second series RC circuit to cause the reduction in the output impedance within a modulation bandwidth of the power amplifier circuit.

## Patentansprüche

1. Integrierte Hüllkurvenverfolgungsschaltung (ETIC), die Folgendes umfasst:
einen Spannungsausgang, der über einen Leitungspfad, der inhärent mit einer induktiven Leiterbahnimpedanz assoziiert ist, mit einer Leistungsverstärkerschaltung gekoppelt ist, wobei die Leistungsverstärkerschaltung dazu ausgelegt ist, ein Hochfrequenz-(HF)-Signal basierend auf einer modulierten Spannung, die an einem Leistungsverstärkereingang empfangen wird, zu verstärken, wobei die modulierte Spannung, die an dem Leistungsverstärkereingang empfangen wird, eine Spannungswelligkeit umfasst, die durch eine Interaktion einer Ausgangsimpedanz, die an dem Leistungsverstärkereingang vorhanden ist, und eines Laststroms in der Leistungsverstärkerschaltung erzeugt wird; und
eine Spannungsmodulationsschaltung, die einen Spannungsverstärker mit einer Ausgangsstufe umfasst, die über einen Rückkopplungspfad, der sich von dem leitfähigen Pfad unterscheidet, mit dem Leistungsverstärkereingang gekoppelt ist, wobei die Spannungsmodulationsschaltung für Folgendes ausgebildet ist:
Erzeugen der modulierten Spannung an dem Spannungsausgang basierend auf einer modulierten Zielspannung;
Empfangen einer modulierten Spannungsrückkopplung, die die modulierte Spannung an dem Spannungsausgang angibt;
Empfangen einer Leistungsverstärkerspannungsrückkopplung, die die Spannungswelligkeit in der modulierten Spannung angibt, die an dem Leistungsverstärkereingang über den Rückkopplungspfad empfangen wird; und
Modifizieren der modulierten Spannung basierend auf der modulierten Spannungsrückkopplung und der Leistungsverstärkerspannungsrückkopplung, um eine Verringerung der Ausgangsimpedanz zu bewirken, um dadurch die Spannungswelligkeit in der modulierten Spannung zu reduzieren, die an dem Leistungsverstärkereingang empfangen wird.

2. ETIC nach Anspruch 1, wobei die Ausgangsimpedanz, die an dem Leistungsverstärkereingang vorhanden ist, eine induktive Impedanz der ETIC und die induktive Leiterbahnimpedanz, die mit dem leitfähigen Pfad assoziiert ist, umfasst.

3. ETIC nach Anspruch 2, wobei die Spannungsmodulationsschaltung Folgendes umfasst:
den Spannungsverstärker, der für die Erzeugung einer anfänglichen modulierten Spannung am Spannungsverstärkerausgang ausgebildet ist auf der Grundlage der modulierten Zielspannung; und
einen Offset-Kondensator, der für die Erzeugung der modulierten Spannung ausgebildet ist, indem er die anfängliche modulierte Spannung um eine Offset-Spannung erhöht.

4. ETIC nach Anspruch 3, wobei der Spannungsverstärker die Ausgangsstufe umfasst, die für Folgendes ausgebildet ist:
Erzeugen der anfänglichen modulierten Spannung an dem Spannungsverstärkerausgang;
Empfangen der Leistungsverstärkerspannungsrückkopplung, die die Spannungswelligkeit in der modulierten Spannung angibt, die an dem Leistungsverstärkereingang empfangen wird; und
Modifizieren der anfänglichen modulierten Spannung basierend auf der Leistungsverstärkerspannungsrückkopplung, um die Verringerung der Ausgangsimpedanz zu bewirken, um dadurch die Spannungswelligkeit in der modulierten Spannung zu reduzieren, die an dem Leistungsverstärkereingang empfangen wird.

5. ETIC nach Anspruch 4, wobei der Spannungsverstärker ferner eine Eingabe/Bias-Stufe umfasst, die für Folgendes ausgebildet ist:
Empfangen der modulierten Zielspannung und der modulierten Spannungsrückkopplung, die die modulierte Spannung an dem Spannungsausgang angibt; und
Erzeugen eines Paars von Vorspannungssignalen basierend auf der modulierten Zielspannung und der modulierten Spannungsrückkopplung, um dadurch zu bewirken, dass die Ausgangsstufe die anfängliche modulierte Spannung erzeugt.

6. ETIC nach Anspruch 5, wobei die Ausgangsstufe Folgendes umfasst:
einen ersten Transistor, der Folgendes umfasst:
eine erste Drain-Elektrode, die dazu ausgelegt ist, eine Versorgungsspannung zu empfangen;
eine erste Gate-Elektrode, die dazu ausgelegt ist, ein erstes Vorspannungssignal unter dem Paar von Vorspannungssignalen zu empfangen; und
eine erste Source-Elektrode, die mit dem Spannungsverstärkerausgang gekoppelt ist; und
einen zweiten Transistor, der Folgendes umfasst:
eine zweite Source-Elektrode, die mit dem Spannungsverstärkerausgang gekoppelt ist;
eine zweite Gate-Elektrode, die dazu ausgelegt ist, ein zweites Vorspannungssignal unter dem Paar von Vorspannungssignalen zu empfangen; und
eine zweite Drain-Elektrode, die mit einer Masse gekoppelt ist;
wobei ein ausgewählter des ersten Transistors und des zweiten Transistors durch ein ausgewähltes des ersten Vorspannungssignals und des zweiten Vorspannungssignals vorgespannt wird, um die anfänglich modulierte Spannung an dem Spannungsverstärkerausgang auszugeben.

7. ETIC nach Anspruch 6, wobei die Ausgangsstufe ferner Folgendes umfasst:
einen ersten Miller-Kondensator, der zwischen die erste Gate-Elektrode und die erste Source-Elektrode gekoppelt ist und dazu ausgelegt ist, eine Impedanz an dem Spannungsausgang zu reduzieren, um dadurch die induktive Impedanz der ETIC zu reduzieren, wenn der erste Transistor durch das erste Vorspannungssignal vorgespannt ist; und
einen zweiten Miller-Kondensator, der zwischen die zweite Gate-Elektrode und die zweite Source-Elektrode gekoppelt ist und dazu ausgelegt ist, die Impedanz an dem Spannungsausgang zu reduzieren, um dadurch die induktive Impedanz der ETIC zu reduzieren, wenn der zweite Transistor durch das zweite Vorspannungssignal vorgespannt ist.

8. ETIC nach Anspruch 6, wobei die Ausgangsstufe ferner Folgendes umfasst:
eine erste Widerstand-Kondensator-(RC)-Reihenschaltung, die zwischen den Leistungsverstärkereingang und die erste Gate-Elektrode gekoppelt ist und dazu ausgelegt ist, die Leistungsverstärkerspannungsrückkopplung mit dem ersten Vorspannungssignal zu kombinieren, um dadurch die induktive Leiterbahnimpedanz an dem Leistungsverstärkereingang zu reduzieren; und
eine zweite RC-Reihenschaltung, die zwischen den Leistungsverstärkereingang und die zweite Gate-Elektrode gekoppelt ist und dazu ausgelegt ist, die Leistungsverstärkerspannungsrückkopplung mit dem zweiten Vorspannungssignal zu kombinieren, um dadurch die induktive Leiterbahnimpedanz an dem Leistungsverstärkereingang zu reduzieren.

9. ETIC nach Anspruch 8, wobei die erste RC-Schaltung und die zweite RC-Schaltung jeweils einen jeweiligen einstellbaren Widerstand und einen jeweiligen einstellbaren Kondensator umfassen, die in Reihe zwischen dem Leistungsverstärkereingang und einer jeweiligen der ersten Gate-Elektrode und der zweiten Gate-Elektrode gekoppelt sind.

10. ETIC nach Anspruch 9, wobei die ETIC ferner eine Steuerschaltung umfasst, die dazu ausgelegt ist, den jeweiligen einstellbaren Widerstand und/oder den jeweiligen Kondensator in einer jeweiligen der ersten RC-Reihenschaltung und der zweiten RC-Reihenschaltung anzupassen, um die Reduzierung der Ausgangsimpedanz innerhalb einer Modulationsbandbreite der Leistungsverstärkerschaltung zu bewirken.

## Revendications

1. Circuit intégré de suivi d'enveloppe, ETIC, comprenant :
une sortie de tension couplée à un circuit amplificateur de puissance par l'intermédiaire d'un trajet conducteur associé intrinsèquement à une impédance de piste inductive, le circuit amplificateur de puissance étant configuré pour amplifier un signal radiofréquence, RF, sur la base d'une tension modulée reçue au niveau d'une entrée d'amplificateur de puissance, dans lequel la tension modulée reçue au niveau de l'entrée d'amplificateur de puissance comprend une ondulation de tension créée par une interaction d'une impédance de sortie se présentant au niveau de l'entrée d'amplificateur de puissance et d'un courant de charge dans le circuit amplificateur de puissance ; et
un circuit de modulation de tension comprenant un amplificateur de tension ayant un étage de sortie couplé à l'entrée d'amplificateur de puissance par l'intermédiaire d'un trajet de rétroaction différent du trajet conducteur, le circuit de modulation de tension étant configuré pour :
générer la tension modulée au niveau de la sortie de tension sur la base d'une tension cible modulée ;
recevoir une rétroaction de tension modulée indiquant la tension modulée au niveau de la sortie de tension ;
recevoir une rétroaction de tension d'amplificateur de puissance indiquant l'ondulation de tension dans la tension modulée reçue au niveau de l'entrée d'amplificateur de puissance par l'intermédiaire du trajet de rétroaction ; et
modifier la tension modulée sur la base de la rétroaction de tension modulée et de la rétroaction de tension d'amplificateur de puissance afin de provoquer une réduction de l'impédance de sortie pour ainsi réduire l'ondulation de tension dans la tension modulée reçue au niveau de l'entrée d'amplificateur de puissance.

2. ETIC selon la revendication 1, dans lequel l'impédance de sortie se présentant au niveau de l'entrée d'amplificateur de puissance comprend une impédance inductive de l'ETIC et l'impédance de piste inductive associée au trajet conducteur.

3. ETIC selon la revendication 2, dans lequel le circuit de modulation de tension comprend :
l'amplificateur de tension configuré pour générer une tension modulée initiale au niveau d'une sortie d'amplificateur de tension sur la base de la tension cible modulée ; et
un condensateur de décalage configuré pour augmenter la tension modulée initiale d'une tension de décalage afin de générer la tension modulée au niveau de la sortie de tension.

4. ETIC selon la revendication 3, dans lequel l'amplificateur de tension comprend l'étage de sortie configuré pour :
générer la tension modulée initiale au niveau de la sortie d'amplificateur de tension ;
recevoir la rétroaction de tension d'amplificateur de puissance indiquant l'ondulation de tension dans la tension modulée reçue au niveau de l'entrée d'amplificateur de puissance ; et
modifier la tension modulée initiale sur la base de la rétroaction de tension d'amplificateur de puissance afin de provoquer la réduction de l'impédance de sortie pour ainsi réduire l'ondulation de tension dans la tension modulée reçue au niveau de l'entrée d'amplificateur de puissance.

5. ETIC selon la revendication 4, dans lequel l'amplificateur de tension comprend en outre un étage d'entrée/de polarisation configuré pour :
recevoir la tension cible modulée et la rétroaction de tension modulée indiquant la tension modulée au niveau de la sortie de tension ; et
générer une paire de signaux de polarisation sur la base de la tension cible modulée et de la rétroaction de tension modulée pour ainsi amener l'étage de sortie à générer la tension modulée initiale.

6. ETIC selon la revendication 5, dans lequel l'étage de sortie comprend en outre :
un premier transistor comprenant :
une première électrode de drain configurée pour recevoir une tension d'alimentation ;
une première électrode de grille configurée pour recevoir un premier signal de polarisation parmi la paire de signaux de polarisation ; et
une première électrode de source couplée à la sortie d'amplificateur de tension ; et
un second transistor comprenant :
une seconde électrode de source couplée à la sortie d'amplificateur de tension ;
une seconde électrode de grille configurée pour recevoir un second signal de polarisation parmi la paire de signaux de polarisation ; et
une seconde électrode de drain couplée à une masse ;
dans lequel l'un, sélectionné, du premier transistor et du second transistor est polarisé par l'un, sélectionné, du premier signal de polarisation et du second signal de polarisation pour délivrer en sortie la tension modulée initiale au niveau de la sortie d'amplificateur de tension.

7. ETIC selon la revendication 6, dans lequel l'étage de sortie comprend en outre :
un premier condensateur de Miller couplé entre la première électrode de grille et la première électrode de source et configuré pour réduire une impédance au niveau de la sortie de tension pour réduire ainsi l'impédance inductive de l'ETIC lorsque le premier transistor est polarisé par le premier signal de polarisation ; et
un second condensateur de Miller couplé entre la seconde électrode de grille et la seconde électrode de source et configuré pour réduire l'impédance au niveau de la sortie de tension pour ainsi réduire l'impédance inductive de l'ETIC lorsque le second transistor est polarisé par le second signal de polarisation.

8. ETIC selon la revendication 6, dans lequel l'étage de sortie comprend en outre :
un premier circuit résistance-condensateur, RC, série couplé entre l'entrée d'amplificateur de puissance et la première électrode de grille et configuré pour combiner la rétroaction de tension d'amplificateur de puissance avec le premier signal de polarisation pour ainsi réduire l'impédance de piste inductive au niveau de l'entrée d'amplificateur de puissance ; et
un second circuit RC série couplé entre l'entrée d'amplificateur de puissance et la seconde électrode de grille et configuré pour combiner la rétroaction de tension d'amplificateur de puissance avec le second signal de polarisation pour ainsi réduire l'impédance de piste inductive au niveau de l'entrée d'amplificateur de puissance.

9. ETIC selon la revendication 8, dans lequel le premier circuit RC et le second circuit RC comprennent chacun une résistance réglable respective et un condensateur réglable respectif couplés en série entre l'entrée d'amplificateur de puissance et l'une, respective, de la première électrode de grille et de la seconde électrode de grille.

10. ETIC selon la revendication 9, dans lequel l'ETIC comprend en outre un circuit de commande configuré pour régler au moins l'un de la résistance réglable respective et du condensateur respectif dans l'un, respectif, du premier circuit RC série et du second circuit RC série pour provoquer la réduction de l'impédance de sortie à l'intérieur d'une largeur de bande de modulation du circuit amplificateur de puissance.
